# EUROPEAN PATENT SPECIFICATION

(11) **EP 4 332 053 B1**
(45) Date of publication and mention of the grant of the patent: **23.10.2024**
(21) Application number: 23190295.8
(22) Date of filing: 08.08.2023
(51) Int. Cl.: B81B 3/00

(54) **ARRANGEMENT OF CARBON NANOTUBES AND A METHOD FOR MANUFACTURING THE ARRANGEMENT**
ANORDNUNG VON KOHLENSTOFFNANORÖHREN UND VERFAHREN ZUR HERSTELLUNG DER ANORDNUNG
AGENCEMENT DE NANOTUBES DE CARBONE ET PROCÉDÉ DE FABRICATION DE L'AGENCEMENT

(30) Priority: 26.08.2022 DE 102022121638
(43) Date of publication of application: 06.03.2024
(73) Proprietor: Technische Universität Darmstadt, 64289 Darmstadt (DE)
(72) Inventor: Yilmazoglu, Oktay, 64846 Groß-Zimmern (DE); Yadav, Sandeep, 64297 Darmstadt (DE); Schneider, Jörg, 64342 Seeheim-Jugenheim (DE); Al-Mafrachi, Yasaameen, 64380 Roßdorf (DE); Preu, Sascha, 67367 Mühltal (DE)
(74) Representative: LifeTech IP Spies & Behrndt Patentanwälte PartG mbB

(56) References cited:
- DE-A1- 102017 115 330
- US-A1- 2016 178 459
- YILMAZOGLU O ET AL: "A nano-microstructured artificial-hair-cell-type sensor based on topologically graded 3D carbon nanotube bundles", NANOTECHNOLOGY, INSTITUTE OF PHYSICS PUBLISHING, BRISTOL, GB, vol. 27, no. 36, 2 August 2016 (2016-08-02), pages 365502, XP020308389, ISSN: 0957-4484, [retrieved on 20160802], DOI: 10.1088/0957-4484/27/36/365502

## Description

The present invention relates to an arrangement of carbon nanotubes, CNTs, a sensor, and a method for manufacturing the arrangement. The present invention also relates to a nanostructured 3-dimensional (3D) bridge structure with an integrated resistance sensor and, in particular, to CNT bridges with a variable position between a substrate surface and a top end.

### BACKGROUND

There is a great need for sensors that can detect a wide variety of sensor quantities in miniaturized form in the smallest of spaces. One possibility is to use so-called MEMS sensors (MEMS = micro-electro-mechanical systems). However, most of these sensors employ separate mechanical, electrical or optical sensors and are based on semiconductor membranes or cantilevers made of silicon or similar materials. In addition to the spring element, an additional sensor is required to read the deflection data. This sensor is often integrated in addition to the component in a complex way, in order to obtain the desired response of the actual sensor element to an exemplary deflection of the spring element. Often, additional on-chip signal processing is also necessary.

However, future generations of sensors will require strongly improved local resolutions (such as for a force measurement in biological cells), high sensitivities, flexibility of use (e.g. for mounting on a curved surface), and/or direct signal processing in case of an integrated sensor.

DE 10 2017 115 330 A discloses a conventional arrangement of CNTs for a sensors or actuator with multiple CNT blocks. A conventional spring element is disclosed in US 2016/0178459 A1 and another conventional arrangement is disclosed in Yilmazoglu et al.: "A nano-microstructured artificial-hair-cell-type sensor based on topologically graded 3D carbon nanotube bundles", NANOTECH-NOLOGY, INSTITUTE OF PHYSICS PUBLISHING, BRISTOL, GB.

Therefore, there is a demand for further arrangements that are suitable as miniaturized sensors.

### BRIEF DESCRIPTION OF THE INVENTION

At least a part of the above problems is solved by an arrangement of carbon nanotubes according to claim 1 and a method for their manufacture according to claim 11. The dependent claims relate to advantageous further embodiments of the subject matter of the independent claims.

The present invention relates to an arrangement of carbon nanotubes, CNTs, the arrangement including: a substrate, a first CNT block rising up from the substrate, a second CNT block also rising up from the substrate, the first CNT block and the second CNT block being spaced apart from each other. The CNT arrangement further includes a CNT link connecting the first CNT block to the second CNT block, wherein the CNTs of the CNT link are oriented in a same direction as the CNTs of the first CNT block and/or the second CNT block.

According to the invention, the CNT link is furthermore configured as a CNT bridge. The CNT bridge touches only the first CNT block and the second CNT block, but not the underlying structure (e.g., a substrate surface).

The orientation of the CNTs can be understood as the axial direction of the tubes as they grow. This is a preferred direction, where one or another CNT may point in a slightly different direction, but the totality of all CNTs comprise the preferred direction.

According to embodiments, the term "rising up" means that the CNTs are aligned in a vertical direction (i.e., the preferred direction for their longitudinal axis is perpendicular to the substrate surface). Thus the preferred direction of CNTs in the first CNT block, the second CNT block and the CNT link is vertical (i.e., perpendicular to a substrate surface). This has the advantage that on a height of the CNT bridge, the CNT bridge can provide an exceptionally homogeneous interconnection (with respect to, e.g., local electrical, mechanical and thermal properties, such as a respective resistivity) between the first CNT block and the second CNT block.

Optionally, according to a disclosure that is not part of the invention, the CNT link includes a CNT wall. For example, the CNT bridge touches only the first CNT block and the second CNT block, but not the underlying structure (e.g., a substrate surface).

The CNT wall, in contrast to the CNT bridge, is directly or indirectly (e.g. via an intermediate layer) attached to a substrate surface.

Optionally, the arrangement includes an adhesion-reducing layer in an area on the substrate that is below the CNT bridge.

Optionally, the CNT link or CNT bridge comprises at least one of the following:
- a predetermined thickness,
- a predetermined width,
- is formed at a predetermined distance above the substrate.

The term "predetermined" can include a specifically set value (e.g. measured in µm). However, it can also be a relative value (e.g. thickness, width, height measured relative to the size of a CNT block).

Optionally, the thickness and/or width and/or spacing changes along the junction between the first CNT block and the second CNT block in a predetermined manner. For example, these quantities may be tapered or configured to be reinforced in a central region.

Optionally, the CNT blocks may all comprise a different geometry. Thus, the CNT blocks can differ from each other in height and/or width and/or depth. Different metallizations between the CNT blocks to be formed and the substrate may be utilized for this purpose.

The CNT blocks do grow vertically upwards in the manufacturing process. However, they are not always along a straight line. Optionally, therefore, the CNTs in the CNT blocks and/or in the CNT link can be configured in a curved manner (e.g. coil- or spiral-shaped).

Optionally, the arrangement includes at least one of the following electrical contactings of the first CNT block and/or the second CNT block:
- a first contact layer for contacting the first CNT block, wherein the first contact layer is formed adjacent to or partially below the first CNT block on the substrate (and may comprise a metal, for example),
- a second contact layer for contacting the second CNT block, the second contact layer being formed adjacent to or partially below the second CNT block on the substrate (may comprise a metal, for example),
- a first broadening of the first CNT block on a side facing the substrate,
- a second broadening of the second CNT block on a side facing the substrate.

The first broadening and second broadening may optionally be configured as CNT blocks on the first contact layer and on the second contact layer, respectively, so as to form a reliable electrical contact to the first CNT block and the second CNT block.

It is understood that embodiments also refer to arrangements that do not comprise electrical contacts. The CNT link or a CNT bridge structure has a small lateral thermal conductivity (compared to the longitudinal direction of the CNT) and can therefore serve as a platform to better measure temperature changes. The evaluation can be done, for example, purely optically via a microscope.

Optionally, the arrangement includes at least one further CNT link connecting the first CNT block to the second CNT block. The CNTs of the further CNT link may be aligned in a same direction as the CNTs of the first CNT block and/or the second CNT block. The at least one further CNT link may be parallel to the CNT bridge. The further CNT link may optionally be a further CNT bridge and may be arranged at least partially above or below the CNT bridge. The terms "below" or "above" may be defined in terms of vertical direction (e.g., along gravity) during use.

Optionally, the CNT link is connected to the at least one further CNT link by a crosslink made of CNT. This crosslink can also be formed from CNTs with the same orientation as the CNT blocks.

Optionally, the arrangement includes one or more further CNT blocks rising up from the substrate. The CNT link and/or the at least one further CNT link may be formed such that they connect the first CNT block, the second CNT block and the one or more further CNT links.

Optionally, the arrangement includes a coating on at least one of the following:
- the CNT link,
- the at least one further CNT link,
- the first CNT block,
- the second CNT block,
- the at least one further CNT block.

The coating may be configured to enhance the thermoresistive effect and/or to provide a pyroelectric, thermochromic, or piezoelectric effect.

Further embodiments relate to a sensor comprising a previously described arrangement of carbon nanotubes (CNTs) and an evaluation unit configured to determine electrical characteristics of the arrangement and, based thereon, to perform at least one of the following measurements with the arrangement:
- a power measurement of an electromagnetic wave,
- a force measurement,
- an acceleration measurement,
- a flow measurement.

During this measurement, quantities such as e.g. an impedance (e.g. via changes of resonance properties), a resistance, generated heat, an electrical voltage may be determined, whereby the determined values depend on deformations or heating of the arrangement. The arrangement is therefore particularly useful for applications in which mechanical deformations or a detection of electrical or optical signals are to be measured. The determined sensor elements can be used in particular for the detection of micro-, millimeter-, THz-waves and/or optical signals (e.g. infrared light).

The good sensing is a consequence of the strong change in resistance of the sensor elements during compressions due to the deflection of the vertically aligned blocks. The deflection e.g. causes the individual CNTs to get in contact with each other and thus change the electric resistance significantly. In this way, the integrated resistance sensor may in particular also be used as a force sensor.

Further embodiments therefore also relate to a use of the described arrangement for at least one of the following applications:
- as a bolometer,
- as a power meter for THz signals,
- as a force meter,
- as an accelerometer.

Further embodiments relate to a method for manufacturing an arrangement of carbon nanotubes, CNTs. The method includes:
- providing a substrate with a substrate surface;
- forming a first CNT block on the substrate surface;
- forming a second CNT block on the substrate surface, wherein the first CNT block and the second CNT block are formed at a distance from each other, wherein the height, width and/or depth of the first and the second CNT block may differ from each other; and
- forming a CNT link connecting the first CNT block with the second CNT block.

The CNTs of the CNT link are aligned in a same direction as the CNTs of the first CNT block and/or the second CNT block.

According to embodiments, the step of forming a CNT link connecting the first CNT block with the second CNT block comprises that the CNT link is lifted locally during the forming of the CNT link in order to form a CNT bridge. This may be achieved by forming the first CNT block, the second CNT block and the CNT link by means of a respective CNT growth process. In the respective process, the CNTs of the CNT link are made to lift off from the substrate surface, such that the CNT bridge is formed.

Optionally, the step of providing the substrate includes forming an adhesion-reducing layer in an area on the substrate surface laterally occupied by the CNT link (i.e., the area is the lateral position of the CNT link).

According to embodiments, the reduction of the adhesion of the CNTs due to the adhesion-reducing layer presents, during a respective CNT growth process of the first CNT block, the second CNT block, and the CNT bridge, an advantageous way of lifting the CNT of the CNT link off the substrate surface. By controlling the CNT growth processes, various parameters of the CNT bridge can be predetermined (i.e., values of the parameters can be selected according to prior specification). These include, in particular, a height of the CNT bridge above the substrate surface, a height of the CNT bridge itself, and (consequentially) a position of the CNT bridge between the substrate surface and a top end of the CNTs of the first CNT block and/or the second CNT block.

It is understood that the steps in the manufacturing process are not necessarily carried out separately. According to embodiments, only one CNT growth process is carried out to produce the described CNT arrangement. Advantageously, the steps are also carried out simultaneously. A separation of the process steps makes a structuring (e.g. a formation of bridges) significantly more difficult.

Embodiments overcome the problems mentioned above by utilization of CNTs that provide the desired functionalities due to their unique properties, e.g., for bolometers or mechanical sensors. These properties include, for example:
- CNTs are one-dimensional carbon structures with a high aspect ratio (ratio of length to radius).
- CNTs can be manufactured in various orientations, dimensions and thicknesses.
- CNT-based nano-electromechanical systems (NEMS) are black bodies with broadband absorption.
- CNTs have excellent electrical, thermal and mechanical properties with highest compressibility, structural flexibility and high thermal and chemical resistance. Free-standing films with vertically oriented carbon nanotubes have a compressibility of up to 85%.

These properties make CNTs an attractive material as novel sensor materials for pressure, vibration and tactile sensors. In particular, the alignment of (almost) all CNTs in a preferred direction significantly improves the sensor properties. In contrast, the use of disordered CNTs is limited due to their non-uniform length, diameter and density. Embodiments therefore represent a simple and inexpensive alternative to the previously established sensors based on semiconductor bending bars or membrane structures.

Further advantages of embodiments include:
- A simple fabrication of 3-dimensional CNT bridge structures becomes possible, whose degrees of freedom can be flexibly adapted. For example, the density, length, height as well as a thickness of the CNT links/CNT bridges can be adapted to the electrical, optical or mechanical sensing.
- Very small sensor dimensions (e.g. edge length <2 µm or less than 10 µm) can be achieved, while still allowing the sensors to be manufactured on a large scale.
- The sensors can comprise simple contacting (micro-nanointegration) for the CNT blocks, e.g. by means of one or more lateral metal contacts.
- Integration of a resistance sensor with high sensor response or sensitivity is possible.
- The 3D CNT sensors can provide a platform for diverse electrical, optical and mechanical applications. For example, flexible and wearable sensors as well as detectors are possible.

These advantages will provide a technologically novel approach and significant performance improvement over currently used bolometers and force sensors based on micro- or nanoelectromechanical systems.

### BRIEF DESCRIPTION OF THE FIGURES

The embodiments of the present invention will be better understood with reference to the following detailed description and accompanying drawings of the various embodiments, which, however, should not be construed as limiting the disclosure to the specific embodiments, but are for explanation and understanding only.
- Fig. 1A: shows an arrangement of carbon nanotubes, CNTs, according to an embodiment of the present invention.
- Fig. 1B: shows an equivalent electrical circuit diagram for the arrangement in Fig. 1A.
- Figs. 2A, 2B: show further advantageous embodiments for the CNT arrangement according to further embodiments.
- Fign. 3A,3B: show top views of the surface of the substrate with the CNT arrangement according to embodiment examples.
- Fig. 4: shows the CNT arrangement according to another embodiment in which multiple CNT bridges are configured.
- Fig. 5: shows another embodiment of the CNT arrangement in which more than two CNT blocks are configured.
- Fig. 6: shows a simplified flow diagram for a method of manufacturing the CNT arrangement according to an embodiment.

### DETAILED DESCRIPTION

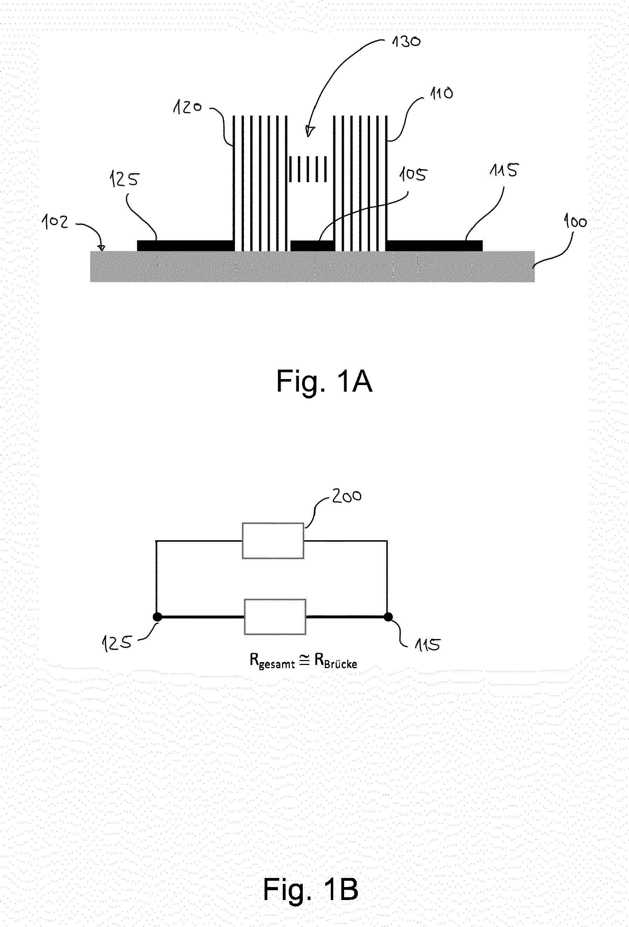

**Fig. 1A** shows an arrangement of carbon nanotubes, CNTs, according to an example embodiment. The arrangement includes: a substrate 100, a first CNT block 110, a second CNT block 120, and a CNT link 130. The first CNT block 110 and the second CNT block 120 are each rising up from the substrate 100 and spaced apart from each other (i.e., not touching). The CNT link 130 connects the first CNT block 110 to the second CNT block 120.

In this and the following figures, it is usually assumed that the CNT link 130 represents a CNT bridge 130. In an example that is not part of the invention, the CNT link 130 may also represent a vertically upstanding wall that contacts the substrate surface 102. All of the features described below with respect to CNT bridge 130 may be configured in the same manner for a general CNT link 130.

The CNTs form tubes that extend linearly in their growth direction. According to embodiments, the CNTs are aligned. In other words, they are not randomly distributed. For example, the CNTs of the CNT bridge 130 have the same orientation as the CNTs of the first CNT block 110 and/or the second CNT block 120. In particular, all CNTs are therefore oriented in a same direction. For example, they extend perpendicular to a substrate surface 102 on which the arrangement is formed.

Further, the arrangement may include an adhesion-reducing layer 105 configured on the substrate surface 102 and located vertically below the CNT bridge 130. The purpose of the adhesion-reducing layer 105 is to prevent or at least reduce adhesion of the CNTs of the CNT bridge 130 to the substrate surface 105. In addition, the growth of the CNTs may be suppressed there. In a manufacturing process, the CNTs grow at least partially from the bottom (substrate side). Since the CNTs of the CNT bridge 130 adhere to the CNTs of the first CNT block 110 and the second CNT block 120, and since the adhesion-reducing layer 105 suppresses growth or adhesion of the CNTs to the adhesion-reducing layer 105, the CNT bridge 130 is lifted vertically upward during the manufacturing process. To achieve this effect, the adhesion-reducing layer 105 may comprise an adapted material, i.e., the material reduces the adhesion to the substrate 100 or the growth rate, compared to the growth rate of the first CNT block 110 and the second CNT block 120, to the substrate 100. For example, the material of the adhesion-reducing layer 105 may comprise a metal such as tantalum.

The arrangement of Fig. 1A further includes a first contacting layer 115 and a second contacting layer 125. The first contacting layer 115 is for electrically contacting the first CNT block 110. The second contacting layer 125 is for electrically contacting the second CNT block 120. The first contacting layer 115 and the second contacting layer 125 may include, for example, a metal, while the substrate 100 may be a dielectric. For example, the first contact layer 115 and the second contact layer 125 may be formed as contact pads. For example, electrical contact may then be made via lateral metallic leads on the substrate, wire bonding, or soldering.

According to further embodiments, the substrate 100 is not an insulator (but is electrically conductive). For example, a conductive substrate 100 may have an insulating layer such as SiO2 (e.g., 600 nm), with the insulating layer configured between the actual substrate 100 and the CNT blocks 110, 120. The substrate 100 may then comprise, for example, silicon with a non-relevant doping. Furthermore, the substrate 100 may comprise hetero layers. For example, multiple metallic conductive layers may be configured in multiple planes. Thus, the vertical contacting of the individual sensor elements can be realized in a more optimized manner.

**Fig. 1B** shows an electrical equivalent circuit diagram for the arrangement of Fig. 1A, which according to embodiment examples is connected to an evaluation unit 200. The evaluation unit 200 can input an electrical signal into the arrangement via the two contact layers 115, 125, or tap a corresponding electrical signal from there, while the CNT arrangement itself represents a variable resistance Rₜₒₜₐₗ. The resistance Rₜₒₜₐₗ changes as a function of various physical quantities and is largely determined by the bridge resistance R_{bridge} of the CNT bridge 130. For example, the electrical resistance can be changed as a function of an applied force, a bending of the CNT, a temperature, a flow rate through a medium, or even an intensity from an incident electromagnetic radiation. This becomes possible because when the arrangement is compressed or deformed, the individual CNTs have an increased interaction or more intense contact with their neighboring CNTs. As a result, the electrical or thermal resistance changes significantly. Since the thermal resistance perpendicular to the CNTs is several orders of magnitude higher than along the CNTs, a lateral heat distribution can be detected very well. Therefore, the arrangement can be used as a highly sensitive sensor.

In embodiments, a variety of evaluation can be performed by the evaluation unit 200. In addition to evaluating the change of the electrical resistance with a deformation or temperature change, optical color changes with the temperature change of the CNT bridge 130 or an additional coating can also be evaluated with a microscope. Optionally, biochemical color changes of an additional coating layer with the CNT bridge 130 or a more complex bridge structure can also be detected, because the light transmission changes and thus modifies the temperature change of the bridge. Furthermore, piezoelectric or pyroelectric coatings of the CNT bridge 130 and/or CNT blocks 110, 120 can be used to generate and evaluate electrical signals (e.g. voltage, current).

The sensor properties can be further improved if the CNT arrangement comprises a coating (not shown in the figures). For example, the coating can change color when the temperature changes, so that a temperature can be measured via optical measurements. The coating may also comprise a thermoelectric, thermochromic, thermosensitive, or piezoelectric material (such as zinc oxide, ZnO, vanadium oxide, VOx). According to the present or further embodiments, the CNT bridge 130 may also serve as a support for a variety of 2D materials (e.g., graphenes, metal sulfides such as MoS2, SnS2, etc.). In this way, highly sensitive piezoresistive sensors with a reproducible lateral resistance decrease can be realized.

Due to their small size (e.g. significantly smaller than 1 mm), embodiments enable high spatial-resolution mechanical sensors, as well as electrical and optical detectors. Measurement of minute deformations with high spatial resolution becomes possible. Also, the low lateral thermal conductivity (parallel to the substrate surface 102) enables the measurement of the smallest temperature changes caused by the absorption of micro-, millimeter-, THz-waves and optical signals (e.g. infrared light).

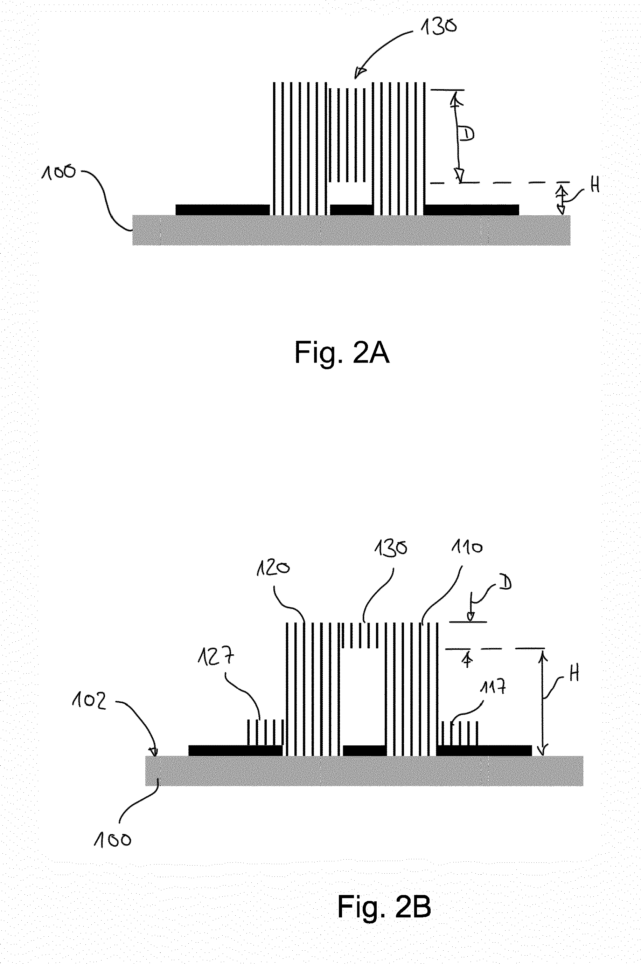

**Figs. 2A** and **2B** show advantageous further developments for the CNT arrangement according to further embodiments. In Fig. 2A, an arrangement is shown in which a thickness D of the CNT bridge 130 is selectively set to a predetermined value. The thickness D may be measured, for example, along the surface normal perpendicular to the substrate surface 102. For example, in the embodiment of Fig. 2A, the thickness D is selected to be larger than in the embodiment of Fig. 2B. Furthermore, in the embodiment of Fig. 2B, the distance H from the substrate surface 102 is larger than in the embodiment of Fig. 1.

This has the technical effect, for example, that the CNT bridge 130 comprises a different electrical resistance. It also makes the CNT bridge 130 more deflectable. Under a shear force, the embodiment of e.g. Fig. 2B will bend more easily than, for example, the arrangement of Fig. 1 or Fig. 2A. However, in the case of the CNT bridge 130 of Fig. 2A, there is a larger point of attack for an exemplary flow that may e.g. be perpendicular to the drawing plane.

Since the more vertically oriented CNT blocks 110, 120 or the CNT bridge 130 are black bodies, they absorb incident radiation in a broadband manner. Therefore, embodiments are very suitable as sensing elements for detecting incident radiation. According to embodiments, the absorption coefficient can be flexibly adjusted by means of the CNT density, thickness D, height H and length of the CNT bridge 130 (cf. Figs. 2A, 2B). The same is true for the thermal conductivity. For example, the thermal resistance perpendicular to the CNTs is several orders of magnitude higher than along the CNTs. Therefore, a lateral heat distribution can be detected very well.

In embodiments, the CNT bridge 130 therefore includes a predetermined geometry that is variably adjustable and can be adapted to the use. The geometry may be determined by the thickness D, the distance or height H from the substrate surface 102, or the length.

The embodiment of Fig. 2B further includes a first broadening 117 and a second broadening 127, configured in a foot portion of the first CNT block 110 and the second CNT block 120, respectively. The first broadening 117 of the first CNT block 110 and the second broadening 127 of the second CNT block 120 serve to improve the electrical contact. For example, the first contact layer 115 may be configured at least partially below the first broadening 117 and the second contact layer 125 may be configured partially or fully below the second broadening 127. This allows an electrical signal (current or voltage) to be introduced or tapped into the CNT arrangement very efficiently. Without the broadenings 117, 127, microcracks could otherwise occur between the contact layers 115, 125 and the CNT blocks 110 120, which would jeopardize the electrical contact.

According to further embodiments, it is possible that the first contact layer 115 is also partially arranged below the first CNT block 110. According to embodiments, it is also possible that the second contact layer 125 is partially arranged below the second CNT block 120.

According to further embodiments, the electrical contacting of the first CNT block 110 or the second CNT block 120 is performed through the substrate 100. For this purpose, vias may be provided in the substrate 100, for example, which do not pick up the electrical signal from the side, but allow electrical contacting from below. Wires may also already be present on the substrate 100 (e.g., as a printed circuit board) that are electrically contacted by the contact layers 115, 125. These arrangements are not shown in the figures.

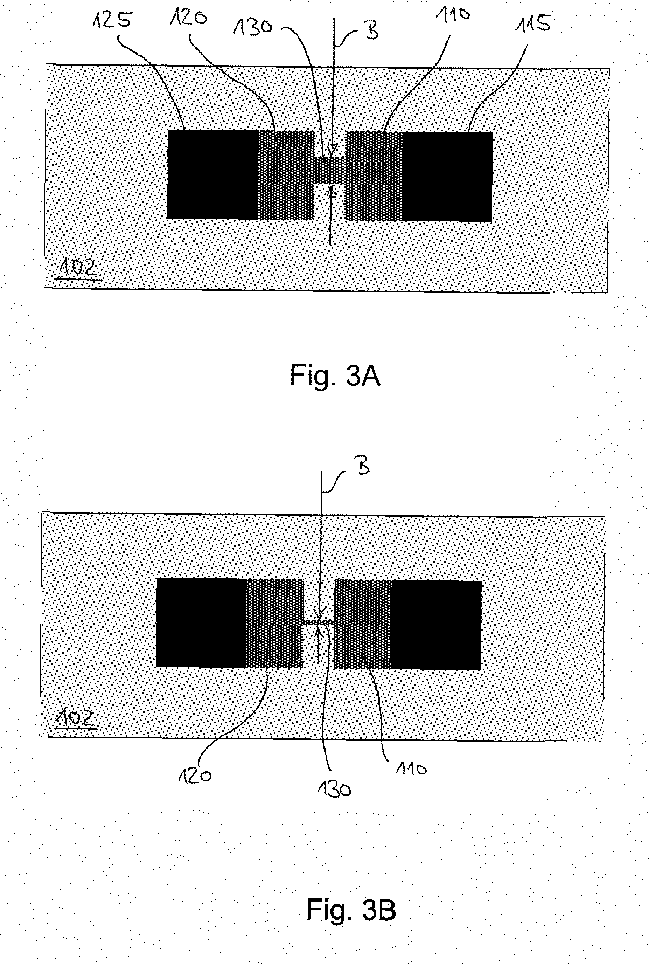

**Figs. 3A, 3B** show top views on further embodiments of the CNT arrangement formed on the surface 102 of the substrate 100, wherein here the CNT bridge 130 comprises a variably adjustable width B. According to the embodiment example shown, the width B of the CNT bridge 130 is wider in the embodiment of Fig. 3A than in the embodiment of Fig. 3B.

According to further embodiments, the width B of the CNT bridge 130 is not constant (i.e., variable) along the line connecting the first CNT block 110 and the second CNT block 120. Similarly, the thickness D of the CNT bridge 130 or the distance H (see, for example, Figs. 2A, 2B) along the line connecting the first CNT block 110 and the second CNT block 120 may be variable rather than constant. Thus, the geometry (e.g., width B, thickness D) of the CNT bridge 130, as well as its distance H above the ground (substrate 100), can be variably selected and adapted to the desired application. Depending on how strongly the CNT arrangement is stressed by the application, the CNT bridge 130 can be selected to be correspondingly thicker or thinner. For example, a thinner bridge is more sensitive with regard to bending, while a CNT bridge 130 with a greater thickness D or width B can withstand greater forces.

The different geometries can be created by means of the design of the adhesion-reducing layer 105. For example, the adhesion-reducing layer 105 may not be homogeneous or may comprise different materials or thicknesses that feed to non-constant growth in the CNT bridge 130. For example, the adhesion-reducing layer 105 may be structured (e.g., striped) to vary the growth rate locally.

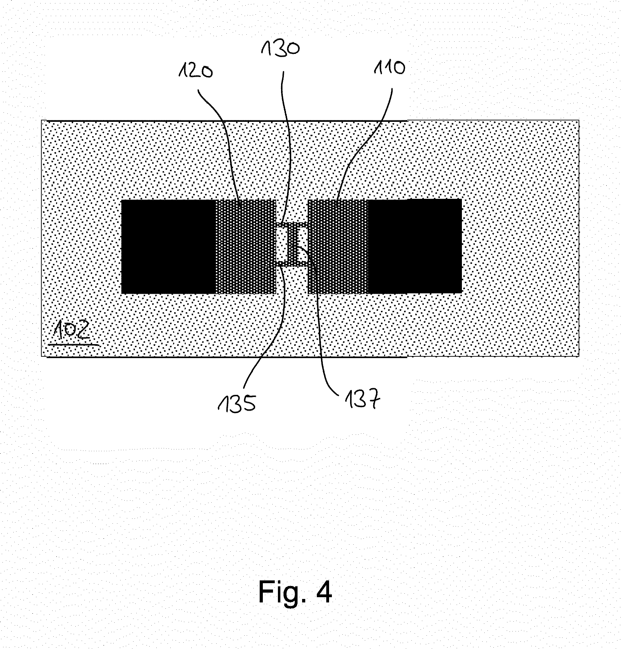

**Fig. 4** shows the CNT arrangement according to a further embodiment, in which not only one bridge connects the first CNT block 110 to the second CNT block 120, but two CNT bridges 130, 135 are configured between the CNT blocks 110, 120. Furthermore, the two CNT bridges 130, 135 are connected to each other via a crosslink 137.

It is understood that according to further embodiments, not only two CNT bridges connect the CNT blocks 110, 120, but more than two CNT bridges may be configured, which may or may not be interconnected.

An advantage of the optional crosslink(s) 137 between the CNT bridges 130, 135 is that it allows the CNT bridges 130, 135 themselves to be formed thinner and improves stability across the crosslink 137. The thin CNT bridges 130, 135 would then be highly sensitive to amendments in electrical or thermal resistance. The crosslinks 137 would then have only a minor influence on the sensitivity, but would ensure that in the desired application the CNT bridges 130, 135 are not destroyed, but are as durable as possible.

According to further embodiments, a large number of CNT bridges 130, 135 are specifically configured so that even if one or the other CNT bridge is lost, the arrangement can still be utilized as a sensor. If necessary, regular calibrations could then become necessary.

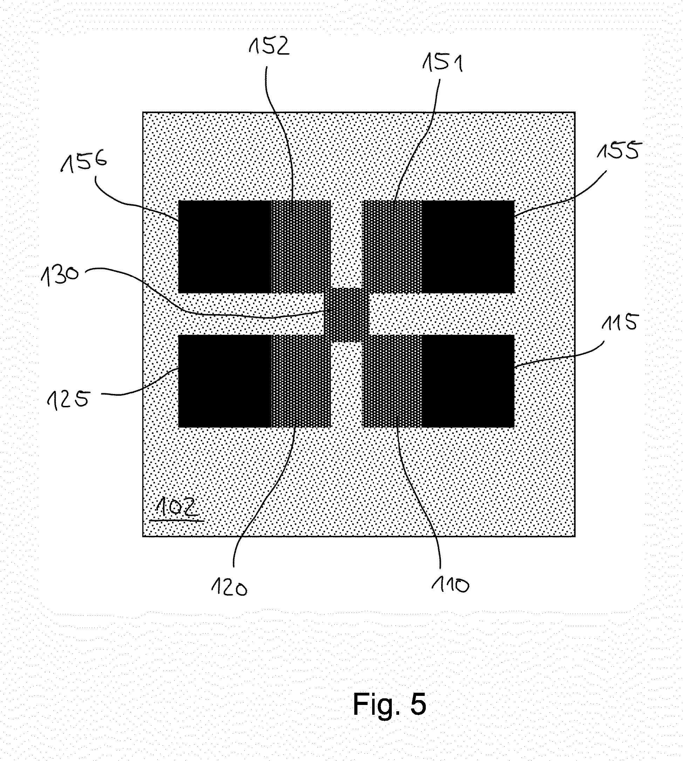

**Fig. 5** shows another embodiment of the CNT arrangement in which, in addition to the first CNT block 110 and the second CNT block 120, two further CNT blocks 151, 152 are configured, all spaced apart from each other. According to this embodiment, the first CNT block 110, the second CNT block 120 and the further CNT blocks 151, 152 are interconnected via one or more CNT bridges 130. In this way, it becomes possible, for example, that sensor variables (forces, accelerations, deformations, flows, irradiations, etc.) can be measured in different directions parallel to the substrate surface 102.

It is understood that also in this embodiment, multiple bridges may be configured one above or one below the other, or additional CNT bridges may be configured between only two or three of the multiple CNT blocks 110, 120, 151, 152.

According to further embodiments, CNT blocks 110, 120 do not include a rectangular cross-section in the horizontal planes (perpendicular to the growth direction). The cross-section may be of any shape (e.g., round, triangular, trapezoidal). In this way, it would be possible for not only two or four CNT blocks to be arranged on the substrate surface 102, but for any number to be arranged in a distributed manner (e.g., as a ring), all or a portion of which are then interconnected via one or more CNT bridges 130. Each CNT block may be electrically contacted individually, for example, to sense sensor variables based on direction.

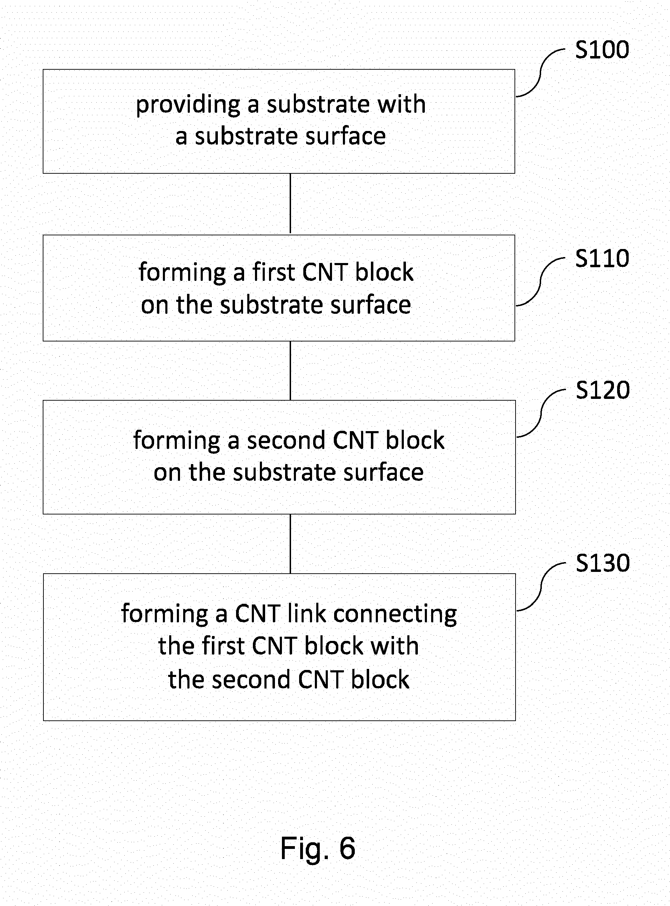

**Fig. 6** shows a simplified flowchart for a method of fabricating an arrangement of carbon nanotubes, CNTs. The method includes:
- Providing S100 of a substrate 100 having a substrate surface 102;
- Forming S110 a first CNT block 110 on the substrate surface 102;
- Forming S120 a second CNT block 120 on the substrate surface 102, wherein the first CNT block 110 and the second CNT block 120 are formed at a distance from each other; and
- Forming S130 a CNT bridge 130 connecting the first CNT block 110 to the second CNT block 120.

The CNTs of the CNT bridge 130 are aligned in a same direction as the CNTs of the first CNT block 110 or the second CNT block 120. For example, forming the CNTs may include a growth process, where the growth direction is an axial direction of the carbon tubes. This growth direction may be the direction along which the CNTs are aligned.

According to embodiments, the CNT bridge 130 is formed by a growth process of CNTs during which these CNTs are made to lift off locally in order to form the CNT bridge 130. In this process, an adhesion between CNT formed in CNT growth processes for forming the first CNT block and the second CNT bock may be employed for lifting the CNT of the CNT bridge off the surface.

The method may further include forming an adhesion-reducing layer 105 in an area on the substrate surface 102 where laterally the CNT bridge 130 is to be located (is below the bridge).

Other optional steps of the method include:
- Etching of the bridge assembly (dry or wet)
- Passivation of the bridge assembly.
- Shrinkage of the bridge assembly (e.g. under the action of acetone).

For example, a completed CNT bridge can be etched with an O2 plasma and thinned. Thus, thinner CNT links are possible. Furthermore, acetone can be used to shrink a tip of the CNT arrangement (e.g., this can be used to adjust the height of CNT blocks 110, 120). The base points can also remain firmly attached to the substrate 100. Thus, denser CNT links are obtained. Depending on the application, the density of the CNT links can also be varied after completion.

It is understood that the method may include further optional steps, such that any of the CNT arrangements described above may be fabricated according to embodiments. Furthermore, it is understood that the order of mention does not necessarily imply an order in the execution of the steps of the method. The steps of the method may also be carried out in a different order, or even in parallel or in one process step. Also, only a part of the steps of the method need to be executed.

The adhesion-reducing layer 105 may e.g. be formed by a patterned thin metal layer (such as tantalum), and the patterning may be performed by optical lithography, for example. In order to influence adhesion during growth of the CNT and a growth rate, e.g. a thickness, width, and type of adhesion-reducing layer 105 may be changed. The combination of adhesion reduction with a low growth rate results in this region lifting off locally during manufacturing, forming the CNT bridge 130 between the vertical CNT blocks 110, 120.

According to further embodiments, additional metal layers can be utilized to completely block growth (see, for example, patterning in Fig. 4). This allows localized vertical walls to be formed between the vertical CNT blocks 110, 120, which then form the CNT bridges 130, 135 and the crosslink 137, respectively. According to this or further embodiments, the fabrication of further combined structures is also possible. For such bridge structures, for example, a strip mask may be employed. In this way, 3-dimensional bridge structures can also be manufactured. Due to the simple optical structuring of the metallizations, the manufacturing process can be varied easily and inexpensively to produce sensors for a wide variety of applications.

According to further embodiments, the diameter of the CNTs can also be adapted on a process-specific basis (e.g. from 1 to 20 nm or from 2 to 8 nm). Similarly, the length of the CNT can be adjusted (e.g., from 1 µm to 3 mm or from 10 µm to 1500 µm). This can be adjusted by adjusting the growth time in the manufacturing process. The height of the CNT blocks 110, 120 can thus also be flexibly adjusted.

Key advantageous aspects of embodiments may be summarized as follows:
Embodiments relate to simple electrical contacting (micro-nanointegration) of CNT sensor elements with bridges and/or thin walls.

Embodiments allow easy customization of the electrical, optical, and mechanical properties for the sensor elements (of the CNT arrangement). The bending properties (such as Young's modulus and bending elasticity), thermal conductivity, absorption rate, and electrical resistivity of the arrangement can be flexibly adjusted for a desired application. For example, the elastic modulus can be less than 400 kPa or less than 200 kPa. These quantities are, for example, the density, thickness, height and length of CNT blocks 110, 120 or CNT link(s) 130, which are adjustable over a wide range.

The CNT arrangement can strongly change the (electrical) resistance upon compression or temperature change depending on the selected geometry. Thus, an integrated resistance sensor with a large sensor response is available. Depending on the geometry of the sensor element, the sensor response can also be adjusted individually.

Embodiments further allow the CNT arrangement to be fabricated on a large scale. It is understood that the full 3D CNT arrangement averages the electrical properties of individual CNTs. The large number of CNTs (several million per mm²) results in a high redundancy. In particular, this greatly facilitates the fabrication of sensors with similar properties. Their simple fabrication combined with the additional possibility of further (chemical) functionalization offer further major advantages. These include, for example:
- The realization of sensors with an extremely small spatial resolution for electrical, optical and/or mechanical characterization of smallest objects like biological cells.
- Diverse imaging applications with micro-, millimeter-, THz-waves and optical signals (e.g. infrared light) become possible.
- Together with small response times, they are also promising for safety, health and industrial applications.
- The utilization of direct optical lithography processes and CNT growth enable easy and inexpensive fabrication.
- Since the CNTs are very good black bodies, broadband absorption of many frequencies is achieved.
- A small Young's modulus (<200 kPa) becomes possible, so that a simple deflection can be used. The Young's modulus can also be adjusted for different applications.
- A spring element without mass is possible (massless bending).
- Small sensor dimensions (edge length <2 µm) and thus highest local resolution are possible. For example, a resolution in the micrometer range can be achieved. On the one hand, this resolution can be achieved with regard to vertical forces or deformations, and on the other hand with regard to shear forces acting parallel to the substrate surface 102.
- Embodiments are very sensitive to bending.
- The vertical orientation of the blocks 110, 120 enables stable electrical contacting and stabilization of the arrangement.
- The sensing elements can change resistance greatly with compression or temperature change and have great sensor sensitivity.
- Direct optical lithography processes and subsequent CNT growth enable simple and inexpensive fabrication.
- Embodiments have minute response times (e.g., <5 ms or <1 ms).
- The bridge arrangement has high thermal stability. Applications at temperatures beyond 200°C are possible.

Based on the above advantages, embodiments may advantageously be used for the following applications:
- A power measurement of electromagnetic waves can be performed (bolometer). In particular, miniaturized microbolometers and force sensors can be realized for high-resolution characterization of smallest objects like biological cells.
- The power of a laser or terahertz radiation can be detected very sensitively (especially in a very small space).
- As mechanical sensors, forces (for example shear forces, but also accelerations or flows) can be measured.
- Flow velocities of gases or liquids can be measured. In this way, the amount of liquid flowing through can also be reliably determined.

The high local resolution (in the µm range) combined with the high sensitivity to a deformation enable applications in sensor technology, where, for example, the following quantities can be sensed: Power of micro, millimeter, THz waves and optical signals (bolometer), force, acceleration, angular velocity, pressure, tactile, vibration, flow (gas, liquid).

The small response times and potential for large-scale fabrication also make the new device promising for safety, health and industrial applications.

The features of the invention disclosed in the description, the claims and the figures may be essential to the realization of the invention either individually or in any combination.

### LIST OF REFERENCE SIGNS

- 100: substrate
- 102: substrate surface
- 105: adhesion-reducing layer
- 110: first CNT block
- 115: first contact layer
- 117: first broadening of the first CNT block
- 120: second CNT block
- 125: second contact layer
- 127: second broadening of the second CNT block
- 130: CNT bridge
- 135: at least one further CNT bridge
- 137: a crosslink
- 151, 152: further CNT blocks
- 200: evaluation unit
- D: thickness of CNT bridge
- B: width of CNT bridge
- H: distance of the CNT bridge from the substrate (height)

## Claims

1. An arrangement of carbon nanotubes, CNTs, including:
a substrate (100);
a first CNT block (no) rising up from the substrate (100);
a second CNT block (120) rising up from the substrate (100), the first CNT block (110) and the second CNT block (120) being spaced apart from each other; and
a CNT link (130) connecting the first CNT block (110) to the second CNT block (120), wherein the CNT link (130) is configured as a CNT bridge,
**characterized in that**
the CNTs of the CNT link (130) are oriented in a same direction as the CNTs of the first CNT block (110) and the second CNT block (120).

2. The arrangement according to claim 1, further comprising:
an adhesion-reducing layer (105) in an area on the substrate (100) that is below the CNT bridge (130).

3. The arrangement according to claim 1 or claim 2, wherein the CNT link (130) comprises at least one of the following properties:
- a thickness (D) that changes along the connection between the first CNT block (110) and the second CNT block (120) in a predetermined manner,
- a width (B) that changes along the connection between the first CNT block (110) and the second CNT block (120) in a predetermined manner,
- is formed at a distance (H) above the substrate (100), wherein the distance (H) changes along the connection between the first CNT block (110) and the second CNT block (120) in a predetermined manner.

4. The arrangement according to any one of claims 1 to 3, comprising at least one of the following electrical contactings of the first CNT block (110) and the second CNT block (120):
a first contact layer (115) for contacting the first CNT block (110), the first contact layer (115) being formed adjacent to or partially below the first CNT block (no) on the substrate (100) and comprising a metal,
a second contact layer (125) for contacting the second CNT block (120), the second contact layer (125) being formed adjacent to or partially below the second CNT block (120) on the substrate (100) and comprising a metal,
a first broadening (117) of the first CNT block (110) on a side facing the substrate (100),
a second broadening (127) of the second CNT block (120) on a side facing the substrate (100).

5. The arrangement according to any one of claims 1 to 4, comprising at least one further CNT link (135), wherein the further CNT link (135) connects the first CNT block (110) to the second CNT block (120) and the CNTs of the further CNT link (135) are aligned in a same direction as the CNTs of the first CNT block (110) or the second CNT block (120).

6. The arrangement according to claim 5, wherein the first CNT link (130) is connected to the at least one further CNT link (135) by a crosslink (137) of CNTs.

7. The arrangement according to any one of claims 1 to 6, further comprising:
at least one further CNT block (151, 152) rising up from the substrate (100),
wherein the CNT link (130) or the at least one further CNT link (135) connects the first CNT block (no), the second CNT block (120), and further CNT block (151, 152).

8. The arrangement according to any one of claims 1 to 7, comprising a coating on at least one of the following:
- the CNT link (130),
- the at least one further CNT link (135),
- the first CNT block (110),
- the second CNT block (120),
wherein the coating is configured to enhance or cause at least one of the following effects: a thermoresistive effect, a pyroelectric effect, a thermochromic effect, a piezoelectric effect.

9. A sensor with:
an arrangement of carbon nanotubes, CNTs, according to any one of claims 1 to 9; and
an evaluation unit (200) configured to determine electrical characteristics of the arrangement and, based thereon, to perform at least one of the following measurements with the arrangement:
- a power measurement of electromagnetic waves,
- a force measurement,
- an acceleration measurement,
- a flow measurement.

10. A use of the arrangement according to any one of claims 1 to 8 for at least one of the following applications:
- as a bolometer,
- as a power meter for THz signals,
- as a force meter,
- as an accelerometer.

11. A method of manufacturing an arrangement of carbon nanotubes, CNTs, the method including:
Providing (S100) a substrate (100) having a substrate surface (102);
Forming (S110), by a growth process, a first CNT block (110) on the substrate surface (102);
Forming (S120), by a growth process, a second CNT block (120) on the substrate surface (102), wherein the first CNT block (no) and the second CNT block (120) are formed at a distance from each other; and
Forming (S130), by a growth process, a CNT link (130) connecting the first CNT block (no) to the second CNT block (120),
wherein the CNTs of the CNT link (130) are aligned in a same direction as the CNTs of the first CNT block (no) and the second CNT block (120), and wherein the CNT link (130) lifts off locally during the manufacturing, forming a CNT bridge.

12. The method according to claim 11, wherein the step of providing (S100) the substrate (100) includes forming an adhesion-reducing layer (105) in an area on the substrate surface (102), the area being a lateral position of the CNT bridge (130).

## Patentansprüche

1. Anordnung von Kohlenstoff-Nanoröhren (CNTs) umfassend:
ein Substrat (100);
einen ersten CNT-Block (110), der vom Substrat (100) aufragt;
einen zweiten CNT-Block (120), der vom Substrat (100) aufragt, wobei der erste CNT-Block (110) und der zweite CNT-Block (120) voneinander beabstandet sind; und
eine CNT-Verbindung (130), die den ersten CNT-Block (110) mit dem zweiten CNT-Block (120) verbindet, wobei die CNT-Verbindung (130) als CNT-Brücke ausgebildet ist,
**dadurch gekennzeichnet, dass**
die CNTs der CNT-Verbindung (130) in die gleiche Richtung orientiert sind wie die CNTs des ersten CNT-Blocks (110) und des zweiten CNT-Blocks (120).

2. Die Anordnung nach Anspruch 1, ferner umfassend:
eine haftungsreduzierende Schicht (105) in einem Bereich auf dem Substrat (100), der sich unterhalb der CNT-Brücke (130) befindet.

3. Die Anordnung nach Anspruch 1 oder Anspruch 2, wobei die CNT-Verbindung (130) mindestens eine der folgenden Eigenschaften umfasst:
- eine Dicke (D), die sich entlang der Verbindung zwischen dem ersten CNT-Block (110) und dem zweiten CNT-Block (120) in einer vorbestimmten Weise verändert,
- eine Breite (B), die sich entlang der Verbindung zwischen dem ersten CNT-Block (110) und dem zweiten CNT-Block (120) in einer vorbestimmten Weise verändert,
- in einem Abstand (H) oberhalb des Substrats (100) ausgebildet ist, wobei sich der Abstand (H) entlang der Verbindung zwischen dem ersten CNT-Block (110) und dem zweiten CNT-Block (120) in einer vorbestimmten Weise verändert.

4. Die Anordnung nach einem der Ansprüche 1 bis 3, umfassend mindestens eine der folgenden elektrischen Kontaktierungen des ersten CNT-Blocks (110) und des zweiten CNT-Blocks (120):
eine erste Kontaktschicht (115) zur Kontaktierung des ersten CNT-Blocks (110), wobei die erste Kontaktschicht (115) angrenzend an oder teilweise unter dem ersten CNT-Block (110) auf dem Substrat (100) ausgebildet ist und ein Metall umfasst,
eine zweite Kontaktschicht (125) zur Kontaktierung des zweiten CNT-Blocks (120), wobei die zweite Kontaktschicht (125) angrenzend an oder
teilweise unter dem zweiten CNT-Block (120) auf dem Substrat (100) ausgebildet ist und ein Metall umfasst,
eine erste Verbreiterung (117) des ersten CNT-Blocks (110) auf einer dem Substrat (100) zugewandten Seite,
eine zweite Verbreiterung (127) des zweiten CNT-Blocks (120) auf einer dem Substrat (100) zugewandten Seite.

5. Die Anordnung nach einem der Ansprüche 1 bis 4, umfassend mindestens eine weitere CNT-Verbindung (135), wobei die weitere CNT-Verbindung (135) den ersten CNT-Block (110) mit dem zweiten CNT-Block (120) verbindet und die CNTs der weiteren CNT-Verbindung (135) in die gleiche Richtung ausgerichtet sind wie die CNTs des ersten CNT-Blocks (110) oder des zweiten CNT-Blocks (120).

6. Die Anordnung nach Anspruch 5, wobei die erste CNT-Verbindung (130) mit der mindestens einen weiteren CNT-Verbindung (135) durch eine Querverbindung (137) von CNTs verbunden ist.

7. Die Anordnung nach einem der Ansprüche 1 bis 6, ferner umfassend:
mindestens einen weiteren CNT-Block (151, 152), der vom Substrat (100) aufragt,
wobei die CNT-Verbindung (130) oder die mindestens eine weitere CNT-Verbindung (135) den ersten CNT-Block (110), den zweiten CNT-Block (120) und den weiteren CNT-Block (151, 152) verbindet.

8. Die Anordnung nach einem der Ansprüche 1 bis 7, umfassend eine Beschichtung auf mindestens einem der folgenden:
- die CNT-Verbindung (130),
- die mindestens eine weitere CNT-Verbindung (135),
- der erste CNT-Block (110),
- der zweite CNT-Block (120),
wobei die Beschichtung so konfiguriert ist, dass sie mindestens einen der folgenden Effekte verstärkt oder verursacht: einen thermoresistiven Effekt, einen pyroelektrischen Effekt, einen thermochromen Effekt, einen piezoelektrischen Effekt.

9. Ein Sensor mit:
einer Anordnung von Kohlenstoff-Nanoröhren (CNTs) nach einem der Ansprüche 1 bis 9; und
einer Auswerteeinheit (200), die konfiguriert ist, elektrische Eigenschaften der Anordnung zu bestimmen und basierend darauf mindestens eine der folgenden Messungen mit der Anordnung durchzuführen:
- eine Leistungsbestimmung elektromagnetischer Wellen,
- eine Kraftmessung,
- eine Beschleunigungsmessung,
- eine Durchflussmessung.

10. Verwendung der Anordnung nach einem der Ansprüche 1 bis 8 für mindestens eine der folgenden Anwendungen:
- als Bolometer,
- als Leistungsmesseinrichtung für THz-Signale,
- als Kraftmesseinrichtung,
- als Beschleunigungsmesser.

11. Ein Verfahren zur Herstellung einer Anordnung von Kohlenstoff-Nanoröhren (CNTs), wobei das Verfahren Folgendes umfasst:
Bereitstellen (S100) eines Substrats (100) mit einer Substratoberfläche (102);
Formen (Siio) eines ersten CNT-Blocks (110) auf der Substratoberfläche (102) durch einen Wachstumsprozess;
Formen (S120) eines zweiten CNT-Blocks (120) auf der Substratoberfläche (102) durch einen Wachstumsprozess, wobei der erste CNT-Block (110) und der zweite CNT-Block (120) mit Abstand voneinander gebildet werden; und
Formen (S130) einer CNT-Verbindung (130), die den ersten CNT-Block (110) mit dem zweiten CNT-Block (120) verbindet, durch einen Wachstumsprozess,
wobei die CNTs der CNT-Verbindung (130) in die gleiche Richtung ausgerichtet sind wie die CNTs des ersten CNT-Blocks (110) und des zweiten CNT-Blocks (120), und wobei die CNT-Verbindung (130) sich während der Herstellung lokal abhebt und eine CNT-Brücke bildet.

12. Das Verfahren nach Anspruch 11, wobei der Schritt des Bereitstellens (S100) des Substrats (100) das Formen einer haftungsreduzierenden Schicht (105) in einem Bereich auf der Substratoberfläche (102) umfasst, wobei der Bereich eine laterale Position der CNT-Brücke (130) ist.

## Revendications

1. Agencement de nanotubes de carbone (CNT), comprenant :
un substrat (100) ;
un premier bloc de CNT (110) s'élevant du substrat (100) ;
un deuxième bloc de CNT (120) s'élevant du substrat (100), le premier bloc de CNT (110) et le deuxième bloc de CNT (120) étant espacés l'un de l'autre ; et
un lien de CNT (130) connectant le premier bloc de CNT (110) au deuxième bloc de CNT (120), le lien de CNT (130) étant configuré comme un pont de CNT,
**caractérisé en ce que**
les CNT du lien de CNT (130) sont orientés dans la même direction que les CNT du premier bloc de CNT (110) et du deuxième bloc de CNT (120).

2. L'agencement selon la revendication 1, comprenant en outre :
une couche de réduction d'adhérence (105) dans une zone sur le substrat (100) qui est en dessous du pont de CNT (130).

3. L'agencement selon la revendication 1 ou la revendication 2, dans lequel le lien de CNT (130) comprend au moins l'une des propriétés suivantes :
- une épaisseur (D) qui change le long de la connexion entre le premier bloc de CNT (110) et le deuxième bloc de CNT (120) d'une manière prédéterminée,
- une largeur (B) qui change le long de la connexion entre le premier bloc de CNT (110) et le deuxième bloc de CNT (120) d'une manière prédéterminée,
- est formé à une distance (H) au-dessus du substrat (100), la distance (H) changeant le long de la connexion entre le premier bloc de CNT (110) et le deuxième bloc de CNT (120) d'une manière prédéterminée.

4. L'agencement selon l'une quelconque des revendications 1 à 3, comprenant au moins l'un des contactages électriques suivants du premier bloc de CNT (110) et du deuxième bloc de CNT (120) :
une première couche de contact (115) pour le contactage du premier bloc de CNT (110), la première couche de contact (115) étant formée adjacente ou partiellement en dessous du premier bloc de CNT (110) sur le substrat (100) et comprenant un métal,
une deuxième couche de contact (125) pour le contactage du deuxième bloc de CNT (120), la deuxième couche de contact (125) étant formée adjacente ou partiellement en dessous du deuxième bloc de CNT (120) sur le substrat (100) et comprenant un métal,
un premier élargissement (117) du premier bloc de CNT (110) sur un côté face au substrat (100),
un deuxième élargissement (127) du deuxième bloc de CNT (120) sur un côté face au substrat (100).

5. L'agencement selon l'une quelconque des revendications 1 à 4, comprenant au moins un autre lien de CNT (135), l'autre lien de CNT (135) connectant le premier bloc de CNT (110) au deuxième bloc de CNT (120), et les CNT de l'autre lien de CNT (135) étant alignés dans la même direction que les CNT du premier bloc de CNT (110) ou du deuxième bloc de CNT (120).

6. L'agencement selon la revendication 5, dans lequel le premier lien de CNT (130) est connecté au moins à un autre lien de CNT (135) par une traverse (137) de CNT.

7. L'agencement selon l'une quelconque des revendications 1 à 6, comprenant en outre :
au moins un autre bloc de CNT (151, 152) s'élevant du substrat (100),
le lien de CNT (130) ou le autre lien de CNT (135) connectant le premier bloc de CNT (110), le deuxième bloc de CNT (120) et l'autre bloc de CNT (151, 152).

8. L'agencement selon l'une quelconque des revendications 1 à 7, comprenant un revêtement sur au moins l'un des éléments suivants :
- le lien de CNT (130),
- au moins un autre lien de CNT (135),
- le premier bloc de CNT (110),
- le deuxième bloc de CNT (120),
le revêtement étant configuré pour améliorer ou provoquer au moins l'un des effets suivants : un effet thermorésistif, un effet pyroélectrique, un effet thermo-chromique, un effet piézoélectrique.

9. Un capteur comprenant :
un agencement de nanotubes de carbone (CNT) selon l'une quelconque des revendications 1 à 9 ; et
une unité d'évaluation (200) configurée pour déterminer les caractéristiques électriques de l'agencement et, sur cette base, pour effectuer au moins l'une des mesures suivantes avec l'agencement :
- une mesure de puissance d'ondes électromagnétiques,
- une mesure de force,
- une mesure d'accélération,
- une mesure de débit.

10. Utilisation de l'agencement selon l'une quelconque des revendications 1 à 8 pour au moins l'une des applications suivantes :
- en tant que bolomètre,
- en tant que wattmètre pour les signaux THz,
- en tant que dynamomètre,
- en tant qu'accéléromètre.

11. Un procédé de fabrication d'un agencement de nanotubes de carbone (CNT), le procédé comprenant :
la fourniture (S100) d'un substrat (100) ayant une surface de substrat (102) ;
la formation (S110), par un processus de croissance, d'un premier bloc de CNT (110) sur la surface du substrat (102) ;
la formation (S120), par un processus de croissance, d'un deuxième bloc de CNT (120) sur la surface du substrat (102), le premier bloc de CNT (110) et le deuxième bloc de CNT (120) étant formés à une distance l'un de l'autre ; et
la formation (S130), par un processus de croissance, d'un lien de CNT (130) reliant le premier bloc de CNT (110) au deuxième bloc de CNT (120),
les CNT du lien de CNT (130) étant alignés dans la même direction que les CNT du premier bloc de CNT (110) et du deuxième bloc de CNT (120), et le lien de CNT (130) se soulève localement pendant la fabrication pour former un pont de CNT.

12. Le procédé selon la revendication 11, dans lequel l'étape de fourniture (S100) du substrat (100) comprend la formation d'une couche de réduction d'adhérence (105) dans une zone sur la surface du substrat (102), la zone étant une position latérale du pont de CNT (130).
